Europäisches Patentamt

**European Patent Office**

Office européen des brevets

(19)

(11) Numéro de publication: **0 028 547**
**B1**

(12) **FASCICULE DE BREVET EUROPÉEN**

(45) Date de publication du fascicule du brevet:
23.03.83

(51) Int. Cl.³: **H 05 K 5/06**

(21) Numéro de dépôt: 80401396.9

(22) Date de dépôt: 02.10.80

(54) **Boîtier hermétique pour dispositif électronique ou électro-optique.**

(30) Priorité: 31.10.79 FR 7927014

(43) Date de publication de la demande:
13.05.81 Bulletin 81/19

(45) Mention de la délivrance du brevet:
23.03.83 Bulletin 83/12

(84) Etats contractants désignés:
**DE GB IT NL**

(56) Documents cités:
**DE-A-2 718 563**

(73) Titulaire: **THOMSON-CSF, 173, Boulevard Haussmann, F-75379 Paris Cedex 08 (FR)**

(72) Inventeur: **Henry, Raymond, "THOMSON-CSF"
SCPI 173, Bld Haussmann, F-75360 Paris Cedex 08 (FR)**
Inventeur: **Dufond, Pierre, "THOMSON-CSF"
SCPI 173, Bld Haussmann, F-75360 Paris Cedex 08 (FR)**
Inventeur: **Foucaud, Didier, "THOMSON-CSF"
SCPI 173, Bld Haussmann, F-75360 Paris Cedex 08 (FR)**

(74) Mandataire: **Giraud, Pierre et al, THOMSON-CSF
SCPI 173, Bld Haussmann, F-75379 Paris Cedex 08 (FR)**

Boîtier hermétique pour dispositif électronique ou électro-optique

L'invention concerne la réalisation d'un boîtier hermétique pour dispositif électronique et/ou électro-optique, notamment en très haute fréquence (au dessus de 1 GHz). Elle a pour but de faciliter la réparation du dispositif électronique ou optique contenu à l'intérieur du boîtier, notamment en remplaçant un composant ou une pastille constituant un sous-ensemble du dispositif.

En effet, si l'on prend l'exemple d'un amplificateur à très haute fréquence à plusieurs étages passifs et/ou actifs, chaque étage est constitué d'un ou plusieurs circuits à haute fréquence à caractéristiques réparties sur lesquels sont reportées ou non une ou plusieurs pastilles nues qui sont des composants semiconducteurs actifs. Une telle pastille nue ne peut-être laissée à l'air libre sans compromettre gravement la fiabilité de l'amplificateur. En conséquence, on protège l'ensemble des éléments de circuit par un boîtier unique à couvercle hermétique et à sorties étanches. Cette solution, moins onéreuse que celle des boîtiers individuels par élément de circuit, est pratiquement rendue nécessaire par l'exigence de couplage optimal des éléments de circuit entre eux. En revanche, en cas de défaillance de l'un des éléments, elle oblige à remplacer l'élément de circuit défectueux en ouvrant le boîtier. Quel que soit le type de fermeture (couvercle soudé ou collé) on doit briser alors l'étanchéité, ce qui nécessite l'intervention d'instruments contondants. Ceci entraîne presque à coup sûr la pollution des pastilles nues, notamment par l'irruption de copeaux, débris et poussières de nature diverse.

Une telle pollution compromet gravement la fiabilité du dispositif; on a proposé, pour y remédier, la fabrication de boîtiers comportant un premier couvercle soudé et un deuxième couvercle vissé. Cette solution est dispendieuse aussi bien en volume qu'en prix de revient.

L'invention tend à remédier à ces inconvénients, en tenant compte du fait qu'on connaît, par le document DE-A-2 718 563, un boîtier hermétique, pour dispositif électronique, selon la préambule de la revendication 1, en particulier comportant deux parties séparables, mécaniquement reliées, dont l'une joue le rôle de couvercle, et dont l'autre, constituant le boîtier proprement dit, comporte une rainure située dans l'épaulement sur lequel appuie le couvercle lors de la fermeture du boîtier hermétique.

Suivant l'invention, un boîtier hermétique pour dispositif électronique comporte au moins une ouverture, destinée à faciliter la mise en place et la réparation ultérieure du dispositif; les bords de cette ouverture sont aménagés pour recevoir un premier couvercle scellé, et les parois de l'ouverture comportent, à l'intérieur du boîtier et sous l'emplacement du couvercle, un épaulement présentant au moins une rainure. Il est caractérisé en ce que cette rainure est conformée de façon à permettre le sertissage par une force extérieure d'une feuille mince de matériau, la feuille constituant un deuxième couvercle.

L'invention sera mieux comprise, et d'autres caractéristiques apparaîtront, au moyen de la description qui suit, et des dessins qui l'accompagnent, parmi lesquels:

La figure 1 est une vue par dessus d'un boîtier selon l'invention, représenté sans aucun couvercle mis en place;

La figure 2 est une coupe du même boîtier suivant un plan de trace 11 visible sur la figure 1;

La figure 3 représente partiellement une variante de l'invention suivant une coupe analogue à celle de la figure 2.

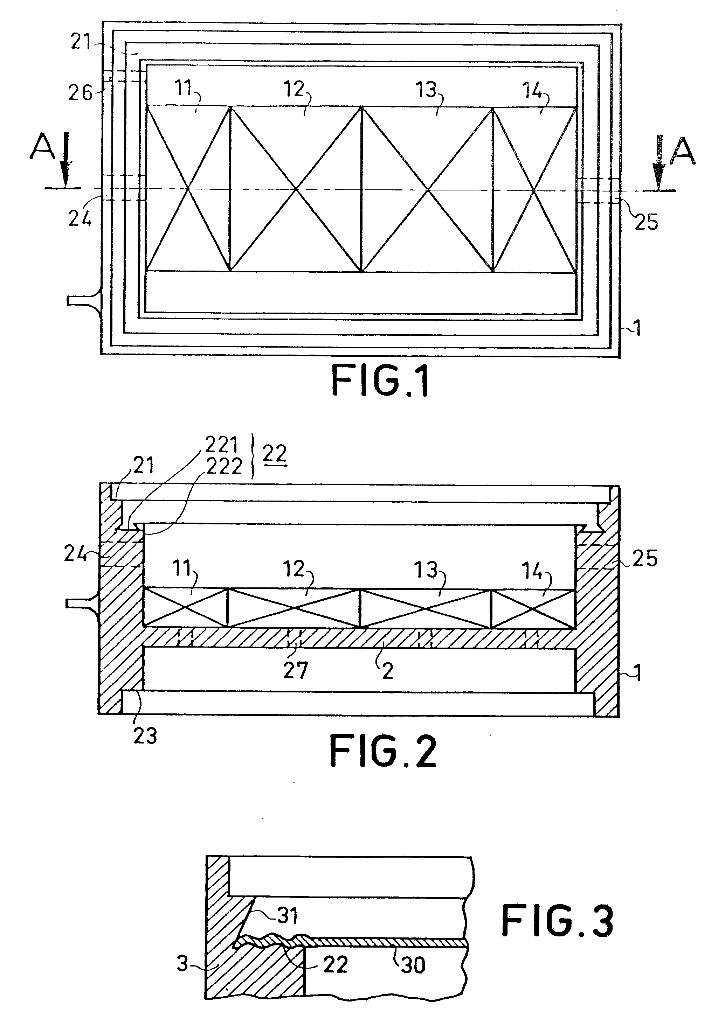

Figures 1 et 2, on a représenté, à titre d'exemple de réalisation de l'invention, une carcasse 1 de boîtier où ont été mis en place des étages comportant des pastilles nues 11 à 14. Ces étages sont représentés avant fixation (par vis) et cablage (par fil nu). En outre, aucun des couvercles n'est figuré.

Le bord interne de la paroi de la carcasse 1 comporte un premier épaulement 21, destiné à permettre le scellement classique du couvercle supérieur. Il comporte un deuxième épaulement situé en dessous du premier et toujours à l'intérieur du boîtier, épaulement 22 comportant une rainure 221, à profil complexe par exemple du type dit »à queue d'aronde« et un rebord 222. Cet épaulement 22 est destiné à fixer la position du deuxième couvercle supérieur, caractéristique de l'invention, matérialisé par exemple par une feuille d'aluminium relativement épaisse que l'on sertit dans la rainure de l'épaulement en faisant pénétrer de force les bords de la feuille dans les rainures 221 sur les quatre côtés de la paroi interne du boîtier. Un tel sertissage s'effectue à l'aide d'instruments de forme classique mais de dimensions adaptées à la miniaturisation habituelle des boîtiers de dispositifs pour très haute fréquence. Cette feuille de métal est éventuellement percée d'un ou plusieurs petits orifices laissant passez les gaz, notamment l'air sec ou l'azote utilisé pour remplir le boîtier avant scellement. De tels orifices ne nuisent pas à la protection des pastilles contre la plus grande partie des poussières ou débris divers lors du descellement du couvercle.

La fixation des pastilles 11 à 14 s'effectue par des vis (non représentées) passant à travers des trous 27 d'une cloison 2 de séparation interne de la partie intérieure du boîtier.

Le cablage électrique des pastilles comporte des raccordements mutuels, d'une part, et d'autre part, des reccordements extérieurs. On n'a représenté aucun de ces types de cablage; mais seulement les orifices utilisés pour le montage préliminaire de traversées isolantes, par exemple par perle de verre, servant à raccorder la polarisation (orifice 26) et les entrées et sorties du dispositif électronique (orifices 24 et 25). Une prise de masse est réalisée par exemple sous la forme d'un picot métallique 10.

De façon classique, le boîtier comporte un épaulement interne 23 à la partie inférieure (côté opposé aux pastilles par rapport à la cloison 2) destiné à la mise en place d'un couvercle scellé (non représenté) analogue au couvercle supérieur classique.

Dans une variante représentée figure 3, l'épaulement 22 a un profil présentant des ondulations constituant une série de rainures parallèles à la paroi. L'épaulement 22 est aménagé figure 3 suivant un profil »rentrant«, ce qui signifie, comme il est visible sur le dessin, que la paroi 3 porte une entaille oblique 31 de façon à augmenter la surface ondulée de l'épaulement 22. Une feuille d'aluminium 30 est sertie par compression de ses bords dans les rainures de l'épaulement 22, de façon également classique.

Dans une autre variante, non représentée, un épaulement analogue à l'épaulement 22 est aménagé à la partie inférieure du boîtier, pour permettre le sertissage d'une autre feuille de métal. Une telle variante s'impose lorsque la cloison 2 ne sépare pas entièrement le boîtier en deux compartiments étanches.

L'invention est applicable aux boîtiers pour dispositifs opto-électroniques, notamment pour les lasers.


## Revendications

1. Boîtier hermétique pour dispositif électronique ou électro-optique comportant au moins une ouverture destinée à faciliter la mise en place et la réparation ultérieure du dispositif, les bords de cette ouverture étant aménagés pour recevoir un premier couvercle scellé, et les parois (21) de cette ouverture comportant, à l'intérieur du boîtier et sous l'emplacement du couvercle, un épaulement (22) présentant au moins une rainure (221), caractérisé en ce que cette rainure (221) est conformée de façon ò permettre le sertissage par une force extérieure d'une feuille mince de matériau, la feuille constituant un deuxième couvercle.

2. Boîtier suivant la revendication 1, caractérisé en ce que l'épaulement (22) présente au moins une rainure (221) en forme de queue d'aronde.

3. Boîtier suivant la revendication 1, caractérisé en ce que l'épaulement (22) présente des ondulations constituant des rainures parallèles à la paroi interne du boîtier.

4. Boîtier suivant la revendication 1, caractérisé en ce qu'il comporte deux ouvertures, la première d'entre elles étant aménagée pour recevoir un couvercle scellé et une feuille mince scellée, et la deuxième étant aménagée pour recevoir seulement un couvercle.

5. Boîtier suivant la revendication 1, caractérisé en ce qu'il comporte deux ouvertures aménagées pour recevoir chacune un couvercle scellé et une feuille mince scellée.


## Patentansprüche

1. Hermetisch abgeschlossenes Gehäuse für eine elektronische oder elektrooptische Vorrichtung, mit wenigstens einer Öffnung zur Erleichterung des Einbringens und der späteren Reparatur der Vorrichtung, wobei die Ränder dieser Öffnung so ausgebildet sind, daß sie einen ersten versiegelten Deckel aufnehmen können, und wobei die Wände (21) dieser Öffnung im Inneren des Gehäuses und unter dem Deckel eine Schulter (22) aufweisen, die wenigstens eine Rille (221) bildet, dadurch gekennzeichnet, daß diese Rille (221) so gestaltet ist, daß sie eine Einfassung einer dünnen Materialfolie durch eine äußere Kraft zuläßt, wobei diese Folie einen zweiten Deckel bildet.

2. Gehäuse nach Anspruch 1, dadurch gekennzeichnet, daß die Schulter (22) wenigstens eine schwalbenschwanzförmige Rille (221) aufweist.

3. Gehäuse nach Anspruch 1, dadurch gekennzeichnet, daß die Schulter (22) Wellungen aufweist, die zu der Innenwand des Gehäuses parallele Rillen bilden.

4. Gehäuse nach Anspruch 1, dadurch gekennzeichnet, daß es zwei Öffnungen aufweist, wovon die erste so ausgebildet ist, daß sie einen versiegelten Deckel und eine dünne versiegelte Folie aufnimmt, und die zweite so ausgebildet ist, daß sie nur einen Deckel aufnimmt.

5. Gehäuse nach Anspruch 1, dadurch gekennzeichnet, daß es zwei Öffnungen aufweist, die so ausgebildet sind, daß jede einen versiegelten Deckel und eine versiegelte Folie aufnimmt.


## Claims

1. Hermetic housing for an electronic or electro-optic device, comprising at least one opening for facilitating locating and subsequent repair of the device, the edges of this opening being arranged to receive a first sealed cover, and the walls (21) of this opening comprising a shoulder (22) having at least one groove (221) inside the housing and under the location of the cover, characterized in that this groove (221) is shaped in a manner to allow setting of a thin material foil by an external force, the foil forming a second cover.

2. Housing in accordance with claim 1, characterized in that the shoulder (22) has at least one groove (221) of dovetail shape.

3. Housing in accordance with claim 1, characterized in that the shoulder (22) has corrugations forming grooves which are parallel to the inner wall of the housing.

4. Housing in accordance with claim 1, characterized in that it comprises two openings the first of which is arranged to receive a sealed cover and a thin sealed foil, and the second being arranged to receive a cover only.

5. Housing in accordance with claim 1, characterized in that it comprises two openings each being arranged to receive a sealed cover and a thin sealed foil.

FIG.1

FIG.2

FIG.3